# EUROPÄISCHE PATENTANMELDUNG

(11) **EP 2 804 224 A1**
(43) Veröffentlichungstag der Anmeldung: **19.11.2014**
(21) Anmeldenummer: 13167552.2
(22) Anmeldetag: 13.05.2013
(51) Int. Cl.: H01L 31/048

(54) **Verfahren zur Herstellung eines Photovoltaikmoduls**

(71) Anmelder: Fraunhofer Gesellschaft zur Förderung der angewandten Forschung e.V., 80686 München (DE)
(72) Erfinder: Schulze, Stefan, 06114 Halle/Saale (DE); Schak, Matthias, 06112 Halle/Saale (DE)
(74) Vertreter: Andrae | Westendorp Patentanwälte Partnerschaft

(57) **Zusammenfassung**

Die Erfindung betrifft ein Verfahren zur Herstellung eines Photovoltaikmoduls (1), bei welchem zumindest eine mit Anschlusskontakten (151) versehene photovoltaische Zelle (15) auf ein Trägermaterial (10) aufgebracht wird und nachfolgend das Trägermaterial (10), die Zelle (15) und zumindest eine Rückseitenfolie (13) flächig miteinander verbunden werden, wobei weiterhin zumindest ein auf der Rückseite (131) des Photovoltaikmoduls angeordnetes Bauteil (16) mit der Rückseitenfolie (13) verschweißt wird, gekennzeichnet durch die folgenden Schritte: Aufnehmen und Positionieren des Bauteils (16) über der für die Montage vorgesehenen Teilfläche (133) der Rückseite (131) des Photovoltaikmoduls (1), Positionieren eines Heizelementes (2) zwischen dem Bauteil (16) und zumindest der für die Montage vorgesehenen Teilfläche (133) der Rückseite (131) des Photovoltaikmoduls (1), Einbringen von Wärmeenergie in die für die Montage vorgesehenen Teilfläche (133) und zumindest eine Teilfläche (161) des Bauteiles (16), Entfernen des Heizelementes (2), Zusammenführen des Bauteils (16) und der für die Montage vorgesehenen Teilfläche (133) mit einem vorgebbaren Anpressdruck, Abkühlen des Bauteils (16) und des Photovoltaikmoduls (1) unter die Glasübergangstemperatur.

## Beschreibung

Die Erfindung betrifft ein Verfahren zur Herstellung eines Photovoltaikmoduls, bei welchem zumindest eine mit Anschlusskontakten versehene photovoltaische Zelle auf ein Trägermaterial aufgebracht wird und nachfolgend das Trägermaterial, die Zelle und zumindest eine Rückseitenfolie flächig miteinander verbunden werden, wobei weiterhin zumindest ein auf der Rückseite des Photovoltaikmoduls angeordnetes Bauteil mit der Rückseitenfolie verschweißt wird.

Ein gattungsgemäßes Photovoltaikmodul ist aus der DE 20 2010 005 210 U1 bekannt. Gemäß diesem Stand der Technik soll ein Photovoltaikmodul eine Mehrzahl von Photovoltaikelementen und streifenförmigen Stromleitern enthalten. Diese Mehrzahl ist zwischen einer frontseitigen Schutzplatte aus Glas und einer Rückwand aus Kunststoff oder Glas angeordnet. Auf der Rückseite befindet sich weiterhin eine Anschlussdose, welche dazu eingerichtet ist, eine witterungsgeschützte Kabelverbindung des Photovoltaikmoduls zu ermöglichen, um die erzeugte elektrische Energie abzuführen. Die Anschlussdose soll auf der Rückseite des Photovoltaikmoduls verschweißt werden. Hierzu stehen Montagelaschen an der Anschlussdose zur Verfügung.

Dieses bekannte Photovoltaikmodul weist den Nachteil auf, dass die Montage der Anschlussdose über zugeordnete Anschlusslaschen zusätzlichen Bauraum auf der Rückseite des Photovoltaikmoduls benötigt. Aufgrund der großen Montagefläche ist zum Schweißen weiterhin ein großer Energieeintrag nötig.

Ausgehend vom Stand der Technik liegt der Erfindung daher die Aufgabe zugrunde, ein rationelles Verfahren zur Herstellung eines Photovoltaikmoduls anzugeben, mit welchem Anschlussdosen oder andere Bauteile rasch und kostengünstig auf der Rückseite des Photovoltaikmoduls befestigt werden können.

Die Aufgabe wird erfindungsgemäß durch ein Verfahren gemäß Anspruch 1, ein Verfahren gemäß Anspruch 5 und ein Verfahren gemäß Anspruch 9 gelöst.

Erfindungsgemäß wird vorgeschlagen, ein an sich bekanntes Photovoltaikmodul auf dessen Rückseite mit zumindest einem Bauteil zu versehen. Das Bauteil kann dabei in einigen Ausführungsformen der Erfindung eine Anschlussdose zur Aufnahme eines Steckverbinders oder einer Kabelklemme sein, um das Photovoltaikmodul an einen Wechselrichter anzuschließen. In anderen Ausführungsformen der Erfindung kann das auf der Rückseite angeordnete Bauteil eine Rückseitenverstärkung sein, um eine Durchbiegung des Photovoltaikmoduls zu verringern oder zu vermeiden. Die Rückseitenverstärkung kann hierzu ein T-Profil, L-Profil oder ein Rechteck- oder Quadratprofil mit hohlem oder massivem Querschnitt sein. In wiederum anderen Ausführungsformen der Erfindung kann das rückseitig angebrachte Bauteil ein Rahmen sein, welcher das Photovoltaikmodul umgrenzt. In wiederum einer anderen Ausführungsform der Erfindung kann das Bauteil ein elektrisches Kabel sein, eine Kabelhalterung oder ein Befestigungselement, mit welchem das Photovoltaikmodul an einer Fassade, einem Dach oder einer Tragstruktur befestigt werden kann.

Das Photovoltaikmodul selbst enthält zumindest ein transparentes oder transluzentes Trägermaterial mit einer ersten Seite und einer gegenüberliegenden zweiten Seite. Weiterhin enthält das Photovoltaikmodul zumindest eine photovoltaische Zelle, beispielsweise aus monokristallinem oder polykristallinem Silizium. Die photovoltaischen Zellen sind auf der ersten Seite des Trägermaterials angeordnet. Die zweite Seite des Trägermaterials kann als Lichteintrittsfläche dienen. Das Trägermaterial kann dazu eingerichtet sein, die photovoltaischen Zellen vor Witterungseinflüssen zu schützen. Den Abschluss des Photovoltaikmoduls bildet zumindest eine Rückseitenfolie, welche flächig mit dem Trägermaterial und den photovoltaischen Zellen verbunden ist. Auf diese Weise wird der Zutritt von Feuchtigkeit zu den photovoltaischen Zellen und den stromführenden Leitern im Inneren des Photovoltaikmoduls verhindert.

Das Trägermaterial kann ein Glas oder einen Kunststoff enthalten. In einigen Ausführungsformen der Erfindung kann das Trägermaterial Polycarbonat, Polyethylen oder Polypropylen enthalten oder daraus bestehen.

Die zumindest eine Rückseitenfolie kann in einigen Ausführungsformen der Erfindung zumindest einen Kunststoff enthalten. In einigen Ausführungsformen der Erfindung kann der Kunststoff ein Polyolefin sein oder einen solchen enthalten. In einigen Ausführungsformen der Erfindung kann das Polyolephin ausgewählt sein aus Polyethylen und/oder Polypropylen. Daneben kann die Rückseitenfolie Polyvinylfluorid enthalten. In einigen Ausführungsformen der Erfindung kann die Rückseitenfolie ein Verbundmaterial aus einer Mehrzahl von Einzelschichten sein oder ein solches Material enthalten. Die Einzelschichten können hierbei aus identischen Materialien bestehen oder aus unterschiedlichen Materialien.

Die vollflächige Verbindung der Rückseitenfolie mit den photovoltaischen Zellen und dem Trägermaterial kann beispielsweise durch heißaktivierbare Klebstoffe erfolgen oder durch Erwärmen unter flächigem Druck, so dass die Rückseitenfolie und das Trägermaterial miteinander verschweißt werden, um auf diese Weise die dazwischen angeordneten photovoltaischen Zellen zu fixieren.

In einigen Ausführungsformen der Erfindung kann zwischen dem Trägermaterial und der Rückseitenfolie zumindest eine weitere Materiallage angeordnet sein, um vorgebbare optische Eigenschaften zu erzielen, die Haftfestigkeit der Rückseitenfolie auf dem Trägermaterial zu verbessern oder um die photovoltaischen Zellen elektrisch zu isolieren und/oder mechanisch zu befestigen. In einigen Ausführungsformen der Erfindung kann eine solche Zwischenlage Ethylenvinylacetat enthalten oder daraus bestehen.

Um das zumindest eine Bauteil auf der Rückseite des Photovoltaikmoduls zu verschweißen, wird in einer Ausführungsform der Erfindung vorgeschlagen, das Bauteil, beispielsweise eine Anschlussdose, über der für die Montage vorgesehenen Teilfläche der Rückseite des Photovoltaikmoduls zu platzieren. Hierzu kann in einigen Ausführungsformen der Erfindung ein Linearantrieb verwendet werden oder ein Industrieroboter, um das Verfahren in der Serienfertigung von Photovoltaikmodulen automatisiert durchzuführen. Sodann wird ein Heizelement zwischen dem Bauteil und der für die Montage vorgesehen Teilfläche der Rückseite des Photovoltaikmoduls positioniert. Durch Absenken des Heizelementes auf die Rückseite des Photovoltaikmoduls und gleichzeitiges Positionieren des Bauteils auf der gegenüberliegenden Seite des Heizelements kann Wärmeenergie in die Teilfläche des Photovoltaikmoduls und in die Kontaktfläche des Bauteils eingebracht werden. Nachdem das Bauteil und/oder die Teilfläche des Photovoltaikmoduls ausreichend erwärmt wurden, kann das Bauteil angehoben werden, um das Heizelement zu entfernen. Das erfindungsgemäße Verfahren weist dabei den Vorteil auf, dass das Bauteil stoffschlüssig mit dem Photovoltaikmodul verbunden ist, so dass sich eine erhöhte Zuverlässigkeit und/oder höhere Haltekräfte ergeben können.

In einigen Ausführungsformen der Erfindung erfolgt die Erwärmung zumindest bis zur Glasübergangstemperatur. Oberhalb der Glasübergangstemperatur werden die Moleküle des Kunststoffes beweglich, die physikalischen Bindungskräfte zwischen den Molekülketten lösen sich und das Material des Bauelements und/oder die Rückseitenfolie wird weich. Bei amorphen Materialien kann am Glasübergang eine sprunghafte Änderung der Materialeigenschaften erfolgen. In einigen Ausführungsformen der Erfindung kann das Bauteil und/oder die Rückseitenfolie aus teilkristallinen Polymeren gefertigt sein, welche auch oberhalb der Glasübergangstemperatur eine erhöhte Festigkeit aufweisen, so dass das Verfahren einfacher durchgeführt werden kann.

In einigen Ausführungsformen der Erfindung erfolgt die Erwärmung zumindest bis zur Schmelztemperatur. Oberhalb der Schmelztemperatur werden auch die Kristallbindungen teilkristalliner Polymere aufgebrochen. Dadurch kann die Verbindung zwischen dem Bauteil und der Rückseitenfolie verbessert sein. Sofern in der nachfolgenden Beschreibung eine Erwärmung bis zur Glasübergangstemperatur gefordert wird, kann dies in einigen Ausführungsformen der Erfindung auch eine weitere Erwärmung bis zur Schmelztemperatur oder darüber hinaus einschließen.

Im nächsten Verfahrensschritt werden das Bauteil und der für die Montage des Bauteils vorgesehene Bereich der Rückseitenfolie des Photovoltaikmoduls mit vorgebbaren Anpressdruck zusammengeführt. Hierdurch vernetzen sich die Materialien der Rückseitenfolie und des Bauteils. Nach dem Abkühlen unterhalb der Glasübergangstemperatur ist das Bauteil dauerhaft mit der Rückseitenfolie verschweißt. Das vorgeschlagene Verfahren kommt somit ohne zusätzliche Klebstoffe aus, welche eine geringere Beständigkeit gegen Umwelteinflüsse aufweisen können, zusätzliche Kosten bei der Herstellung des Photovoltaikmoduls hervorrufen und aufgrund ihrer Lösemittelhaltigkeit aufwändige Sicherheitsmaßnahmen bei der Verarbeitung erfordern. Da das Bauteil mit seiner gesamten Kontaktfläche mit der Rückseitenfolie verschweißt werden kann, können zusätzliche Montagelaschen entfallen, ohne die Haftfestigkeit des Bauteils nachteilig zu beeinflussen.

Durch die Verwendung eines einzigen Heizelementes kann das Verfahren rationell und mit geringem apparativem Aufwand durchgeführt werden, das ein einziger Linearantrieb bzw. ein einzelner Industrieroboter ausreichend ist, um das Heizelement zwischen Bauteil und Photovoltaikelement einzuführen und vor dem endgültigen Verschweißen wieder zu entfernen.

In einigen Ausführungsformen der Erfindung kann das Verfahren mit einem ersten Heizelement durchgeführt werden, welches zur Erwärmung des auf dem Photovoltaikmodul zu verschweißenden Bauteils dient. Weiterhin kann ein zweites Heizelement vorgesehen sein, welches die für die Montage vorgesehene Teilfläche der Rückseite des Photovoltaikmoduls erwärmt. Beide Heizelemente können durch zugeordnete Linearführungen oder Industrieroboter bewegt werden, um die Bauteile, bzw. die Photovoltaikmodule für eine vorgebbare Zeit mit den Heizelementen in Kontakt zu bringen. In einigen Ausführungsformen der Erfindung kann das erste Heizelement ortsfest angeordnet sein, wobei nur das Bauteil mittels entsprechender Aktoren zunächst mit dem ersten Heizelement und dann mit der Rückseite des Photovoltaikmoduls in Kontakt gebracht wird.

Nachdem beide Teile hinreichend erwärmt wurden, wird das erste Heizelement vom zu montierenden Bauteil und das zweite Heizelement von der Rückseite des Photovoltaikmoduls entfernt und das Bauteil wird auf der für die Montage vorgesehenen Teilfläche der Rückseitenfolie mit einem vorgebbaren Anpressdruck positioniert. Nach Abkühlen des Bauteils und des Photovoltaikmoduls unter die Glasübergangstemperaturen der verwendeten Materialien ist das Bauteil dauerhaft und stoffschlüssig mit dem Photovoltaikmodul verbundenen. Die Verwendung von zwei Heizelementen erlaubt dabei die Wahl einer materialangepassten Temperatur, so dass sowohl das Bauteil als auch die Rückseitenfolie optimal erwärmt werden können, ohne durch übermäßige Erwärmung Schäden in einem der Fügepartner zu erzeugen.

Die zur Erwärmung über die Glasübergangstemperatur erforderliche Zeitspanne richtet sich dabei nach der Glasübergangstemperatur, der Dicke und Zusammensetzung der Rückseitenfolie und dem für das Bauteil gewählten Material. In einigen Ausführungsformen der Erfindung kann die Zeitdauer zum Erwärmen der beiden zu fügenden Teile zwischen etwa 2 s und etwa 20 s oder zwischen etwa 5 s und etwa 10 s betragen.

In einigen Ausführungsformen der Erfindung kann das Bauteil vor dessen Erwärmung auf der Rückseitenfolie des Photovoltaikmoduls platziert werden. In diesem Fall kann ein Fügepartner oder beide Fügepartner eine Temperatur unterhalb der Glasübergangstemperatur aufweisen. In einigen Ausführungsformen der Erfindung können sich beide Fügepartner beim Zusammenfügen auf Raumtemperatur befinden. In diesem Fall kann eine Feinpositionierung des Bauteils erfolgen, da es sich nicht sofort mit der Rückseitenfolie verbindet.

Nach dem Positionieren des Bauteils auf der für die Montage vorgesehenen Teilfläche der Rückseitenfolie des Photovoltaikmoduls kann eine Wärmequelle in Kontakt mit dem Bauteil und der Rückseitenfolie gebracht werden, um zumindest einen Fügepartner zumindest teilweise über die Glasübergangstemperatur zu erwärmen. Nach dem Entfernen der Wärmequelle kühlen das Bauteil und das Photovoltaikmodul unter die Glasübergangstemperatur ab, so dass die Verschweißung beider Fügepartner erfolgt. Als Wärmequelle zum Aufschmelzen der Oberfläche zumindest eines Fügepartners kann in einigen Ausführungsformen ein Heizelement verwendet werden, welches durch direkten Kontakt mit dem Bauteil und/oder der Rückseitenfolie Wärmeenergie durch Wärmeleitung einträgt. In anderen Ausführungsformen der Erfindung kann als Wärmequelle eine kohärente oder inkohärente Strahlungsquelle verwendet werden, welche eine elektromagnetische Strahlung in den Verbindungsbereich beider Fügepartner einbringt, so dass ein Aufschmelzen zumindest einer Oberfläche erfolgt. In einigen Ausführungsformen der Erfindung kann die elektromagnetische Strahlung im infraroten Spektralbereich gewählt sein und beispielsweise eine Wellenlänge zwischen etwa 50 µm und etwa 1 µm oder zwischen etwa 20 µm und etwa 2 µm oder zwischen etwa 5 µm und etwa 3 µm aufweisen.

In einigen Ausführungsformen der Erfindung kann das Heizelement eine zu der für die Montage vorgesehenen Teilfläche des Photovoltaikmoduls komplementär geformte zweite Seite und eine zu der Montagefläche des Bauteils komplementär geformte erste Seite aufweisen. Sofern die Rückseite des Photovoltaikmoduls als weitgehend ebene Fläche ausgeführt ist, kann auch das Heizelement zwei ebene Flächen aufweisen, so dass sich ein scheibenförmiges Heizelement ergibt. Sofern das Photovoltaikmodul eine komplexere Rückseite aufweist, beispielsweise eine sphärische Fläche oder eine asphärische Freiformfläche, kann das Heizelement eine hierzu komplementär geformte Oberfläche aufweisen, so dass das Heizelement in einfacher Weise vollflächig mit der Teilfläche des Bauteils und der Teilfläche der Rückseite des Photovoltaikmoduls in Kontakt gebracht werden kann, um einen zuverlässigen Wärmeübergang sicherzustellen.

In einigen Ausführungsformen der Erfindung kann das Heizelement so ausgestaltet sein, dass die erste Seite und die zweite Seite bei Betrieb des Heizelements unterschiedliche Temperaturen aufweisen. Hiermit kann der Wärmeeintrag in die vergleichsweise dünne Rückseitenfolie des Photovoltaikmoduls geringer sein als der Wärmeeintrag in das zu verschweißende Bauteil, so dass bei gleicher Kontaktzeit beide Fügepartner bis zur Glasübergangstemperatur erwärmt werden und Hitzeschäden an einem Fügepartner vermieden werden können.

In einigen Ausführungsformen der Erfindung kann das Heizelemente eine zu der für die Montage vorgesehenen Teilfläche der Rückseite des Photovoltaikmoduls komplementär geformte zweite Seite aufweisen und weiterhin eine Aussparung aufweisen, welche zur Aufnahme zumindest eines Teilvolumens des Bauteils ausgebildet ist. Ein solches Heizelement erlaubt es, nicht nur die unmittelbare Kontaktfläche des Bauteils bis zur Glasübergangstemperatur zu erwärmen, sondern auch angrenzende Seitenwände. Hierdurch kann der Wärmeverlust über die Seitenwände verringert werden und/oder durch Aufschmelzen der Seitenwände eine größere Verbindungsfläche und damit eine stabilere Verschweißung erzeugt werden.

In einigen Ausführungsformen der Erfindung kann das Heizelement ringförmig sein. Ein ringförmiges Heizelement kann eine runde oder polygonale Querschnittsfläche aufweisen. Das ringförmige Heizelement kann eine Aussparung umschließen, deren Querschnitt komplementär zum Querschnitt des Bauteils geformt sein kann. In diesem Fall kann das Bauteil mit einer Temperatur unterhalb der Glasübergangstemperatur auf dem Photovoltaikelement platziert werden, ehe das Heizelement übergestülpt wird, um die Fügestelle durch Wärmeleitung oder Wärmestrahlung über die Glasübergangstemperatur hinaus zu erwärmen.

Die Heizelemente können in einigen Ausführungsformen der Erfindung durch Induktionsheizung und/oder durch Widerstandsheizung beheizbar sein. Dies erlaubt eine zuverlässige Beheizung der Heizelemente, eine einfache elektronische Regelung der Betriebstemperatur und das Vermeiden von Verbrennungsrückständen, welche bei der Beheizung durch flüssige oder gasförmige Brennstoffe auftreten können.

In einigen Ausführungsformen der Erfindung können zumindest die Kontaktflächen des Heizelements und/oder des ersten Heizelements und/oder des zweiten Heizelements mit einer Beschichtung versehen sein, um ein Anhaften des Kunststoffmaterials der Rückseitenfolie und/oder des Bauteils zu vermeiden.

Sofern das Verschweißen durch Absorption einer elektromagnetischen Strahlung im Verbindungsbereich der Fügepartner erfolgt, kann zwischen dem Bauteil und der für die Montage vorgesehen Teilfläche der Rückseite des Photovoltaikmoduls ein strahlungsabsorbierender Farbstoff beispielsweise bei der Fertigung des Bauteils und/oder der Rückseitenfolie der Kunststoffmasse zugefügt werden, so dass die Bauteile die zur Verschweißung vorgesehene elektromagnetische Strahlung an der Fügestelle bevorzugt absorbieren. In anderen Ausführungsformen der Erfindung kann der Farbstoff durch Aufstreichen, Drucktechniken, Rakeln oder Spritzen auf die Kontaktfläche zumindest eines Fügepartners aufgetragen werden. Als strahlungsabsorbierender Farbstoff kann beispielsweise Nigrosin oder Ruß verwendet werden.

In einigen Ausführungsformen der Erfindung kann die zur Verschweißung verwendete elektromagnetische Strahlung kohärente Strahlung sein. In einigen Ausführungsformen der Erfindung kann eine solche kohärente Strahlung durch einen Diodenlaser und/oder einen CO₂-Laser bereitgestellt werden. Dies erlaubt eine einfache Steuerung der Strahlungsquelle über elektrische Signale, eine gute Fokussierung auf die Fügestelle und aufgrund großer Intensitäten der Strahlung einen raschen Schweißvorgang mit kurzen Taktzeiten.

Das erfindungsgemäß vorgeschlagene Schweißverfahren kann bevorzugt durchgeführt werden, wenn das Bauelement und/oder die Rückseitenfolien aus einem thermoplastischen Kunststoff besteht oder einen solchen enthält.

Nachfolgend soll die Erfindung anhand von Figuren ohne Beschränkung des allgemeinen Erfindungsgedankens näher erläutert werden. Dabei zeigt
- Figur 1: einen Querschnitt durch ein Photovoltaikmodul.
- Fig.2: zeigt schematisch eine Vorrichtung zur Durchführung einer zweiten Verfahrensvariante der Erfindung.
- Figur 3: zeigt schematisch eine Vorrichtung zur Durchführung einer ersten Verfahrensvariante der Erfindung.
- Figur 4: zeigt schematisch eine Vorrichtung zur Durchführung einer dritten Verfahrensvariante der Erfindung.
- Figur 5: schematisch eine Vorrichtung zur Durchführung einer vierten Verfahrensvariante der Erfindung.
- Figur 6: zeigt ein Flussdiagramm, welches die erste Variante des Verfahrens verdeutlicht.
- Figur 7: zeigt ein Flussdiagramm, welches die zweite Variante des Verfahrens verdeutlicht.
- Figur 8: zeigt ein Flussdiagramm, welches die dritte Variante des Verfahrens verdeutlicht.
- Figur 9: zeigt ein Flussdiagramm, welches die vierte Variante des Verfahrens verdeutlicht.

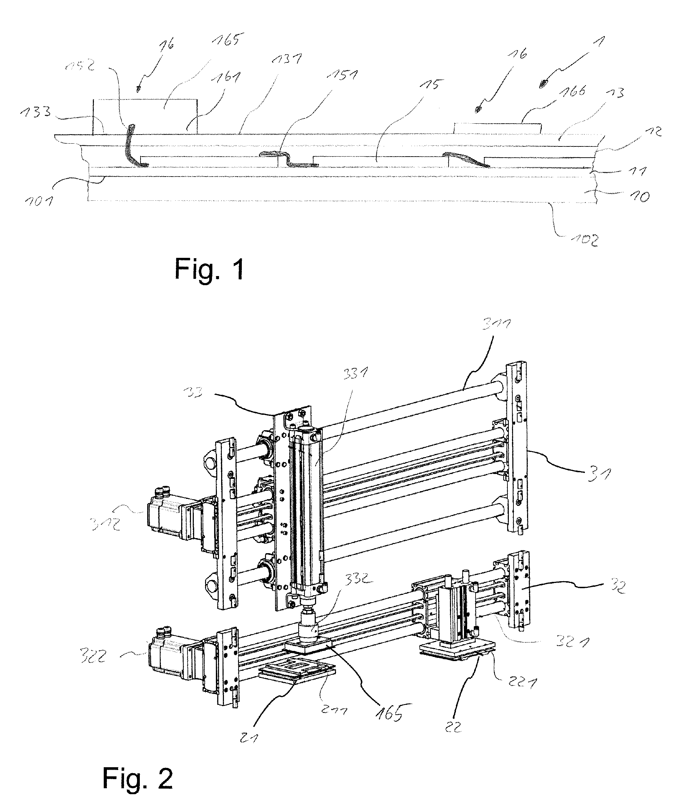

Figur 1 zeigt einen Querschnitt durch ein Photovoltaikmodul gemäß der vorliegenden Erfindung. In Figur 1 ist ein Trägermaterial 10 dargestellt. Das Trägermaterial 10 ist zumindest in Teilflächen transparent oder transluzent, um das Eindringen von Sonnenstrahlung zu ermöglichen. Das Trägermaterial 10 kann in einigen Ausführungsformen der Erfindung ein Glas oder ein Kunststoff sein. Sofern das Trägermaterial 10 einen Kunststoff enthält, kann dieser ausgewählt sein aus einem Polyolephin, Polyethylen, Polycarbonat oder Polypropylen. Meist wird das Trägermaterial 10 elektrisch isolierend sein.

Das Trägermaterial 10 weist eine Lichteintrittsfläche 102 auf. Die Lichteintrittsfläche 102 kann beschichtet sein, beispielsweise um Reflexionen zu vermindern oder um vorzeitige Alterung durch Witterungseinflüsse zu vermeiden.

Auf der der Lichteintrittsfläche 102 gegenüberliegenden Seite 101 kann eine optionale erste Einbettungsfolie 11 angeordnet sein. Die Einbettungsfolie 11 kann beispielsweise Polyvinylacetat und/oder Ethylenvinylacetat enthalten oder daraus bestehen. In anderen Ausführungsformen der Erfindung kann die Einbettungsfolie 11 auch entfallen. Eine Einbettungsfolie 11 kann aus einem Folienverbund mit einer Mehrzahl von Einzelschichten bestehen. Die Einbettungsfolie 11 kann elastisch sein, um mechanische Spannungsspitzen auf die photovoltaischen Zellen 15 zu vermeiden.

Auf der optionalen Einbettungsfolie 11 oder unmittelbar auf dem Trägermaterial 10 ist zumindest eine photovoltaische Zelle 15 angeordnet. Sofern eine Mehrzahl photovoltaischer Zellen 15 im Photovoltaikmodul 1 vorhanden ist, können diese durch elektrische Anschlusskontakte 151 seriell und/oder parallel miteinander verschaltet sein. Die Verschaltung der photovoltaischen Zellen kann beispielsweise durch Löten oder Schweißen erfolgen. Die jeweils letzte Zelle einer Mehrzahl von seriell miteinander verschalteten photovoltaischen Zellen 15 kann einen elektrischen Anschlusskontakt 152 aufweisen, welcher mit einer Schraubklemme oder einem Steckverbinder verbunden ist, um den Anschluss eines Kabels zu ermöglichen.

Auf den photovoltaischen Zellen 15 kann eine optionale zweite Einbettungsfolie 12 angeordnet sein. Die zweite Einbettungsfolie 12 kann zusammen mit der ersten Einbettungsfolie 11 die mechanische Fixierung der photovoltaischen Zellen 15 sicherstellen, so dass die photovoltaischen Zellen zuverlässig ihre Position hinter dem Trägermaterial 10 behalten, auch wenn das Photovoltaikmodul 1 auf einem geneigtem Dach montiert oder beim Transport oder Betrieb Vibrationen ausgesetzt wird. Darüber hinaus kann die erste Einbettungsfolie 11 und die zweite Einbettungsfolie 12 elektrisch isolierend ausgestaltet sein, um einen Kurzschluss bzw. eine Überbrückung einzelner photovoltaischer Zellen 15 zu vermeiden.

Als Witterungsschutz wird eine Rückseitenfolie 12 aufgebracht. Die Rückseitenfolie 12 kann in einigen Ausführungsformen der Erfindung ein Folienverbund aus einer Mehrzahl von Schichten sein. Hierdurch können die unterschiedlichen Anforderungen an die Außenseite 131 und an die der zweiten Einbettungsfolie 12 zugewandten inneren Seite in einfacher Weise erfüllt werden. Beispielsweise soll die innere Seite eine hohe Haftfestigkeit aufweisen und einen großen Reflektionsgrad aufweisen. Demgegenüber besteht die Aufgabe der Außenseite 131 vornehmlich in einem Witterungsschutz, d.h. das Eindringen von Feuchtigkeit oder Staub soll vermieden werden, um die Lebensdauer des Photovoltaikmoduls 1 zu verlängern.

In einigen Ausführungsformen der Erfindung kann die Rückseitenfolie 13 eine Lage Polyethylen zwischen zwei Lagen Polyvinylfluorid enthalten. In anderen Ausführungsformen der Erfindung können unterschiedliche Polyamide miteinander verklebt oder laminiert werden, um eine Rückseitenfolie 13 zu bilden.

Das Trägermaterial 10, die Einbettungsfolien 11 und 12, die photovoltaischen Zellen 15 und die Rückseitenfolie 13 können durch vollflächiges Verkleben oder Laminieren bzw. Verschweißen miteinander dauerhaft verbunden werden, so dass die photovoltaischen Zellen 15 vor Witterungseinflüssen geschützt sind und ein mechanisch stabiles, einfach handhabbares und langlebiges Photovoltaikmodul 1 erhalten wird.

Auf der Rückseite 131 des Photovoltaikmoduls 1 kann zumindest ein Bauteil 16 angeordnet sein. Im dargestellten Ausführungsbeispiel ist eine Anschlussdose 165 gezeigt, welche den Anschlusskontakt 152 aufnimmt, so dass eine Kabelverbindung vor Witterungseinflüssen geschützt ausgeführt werden kann. Weiterhin zeigt Figur 1 beispielhaft eine Rückseitenverstärkung 166 in Form eines rechteckigen Profils, welches die mechanische Stabilität des Photovoltaikmoduls 1 verbessern kann. Daneben können weitere Bauteile 16 vorhanden sein, beispielsweise elektrische Anschlusskabel, Kabelführungen, Rahmenbauteile, oder weitere, hier nicht näher bezeichnete Teile. Die nachfolgenden Figuren 2 bis 5 beschreiben das erfindungsgemäße Verfahren anhand einer Anschlussdose 165. Dies soll jedoch keinesfalls beschränkend ausgelegt werden. Andere Bauteile 16 können in gleicher Weise mit der Rückseite 131 des Photovoltaikmoduls 1 verschweißt werden.

Zur stoffschlüssigen Montage des Bauteils 16 wird eine dem Photovoltaikmodul 1 zugewandte Teilfläche 161 des Bauteils 16 mit einer Teilfläche 133 der Rückseitenfolie 13 verschweißt. Die Verschweißung erfolgt durch Erwärmen der Teilfläche 161 und/oder der Teilfläche 133 über die Glasübergangstemperatur, während beide Fügepartner miteinander in Kontakt stehen. Hierdurch kommt es zur Vernetzung bzw. teilweisen Durchmischung der Polymere beider Fügepartner, so dass nach dem Abkühlen unter die Glasübergangstemperatur ein stabiler Materialverbund an der Fügestelle 161, 133 entsteht.

Figur 2 zeigt eine zweite Variante des erfindungsgemäßen Verfahrens. Figur 1 zeigt einen ersten Linearantrieb 31, welcher einen Schlitten 33 an Führungsstangen 311 umfasst. Durch Antriebsmittel 312 kann der Führungsschlitten 33 entlang der Führungsschienen 311 bewegt werden. Am Führungsschlitten 33 befindet sich ein weiterer Linearantrieb 331, an dessen Ende ein Greifer 332 angeordnet ist. Der Greifer 332 ist dazu eingerichtet, eine Anschlussdose 165 bzw. ein Bauteil 16 aufzunehmen, welches der Vorrichtung beispielsweise über ein Förderband oder aus einem Vorratskarton zugeführt wird.

Weiterhin weist die Vorrichtung ein erstes Heizelement 21 auf, welches eine beheizte erste Seite 211 aufweist. Die Seite 211 des Heizelements 21 ist komplementär zur Teilfläche 161 der Anschlussdose 16 geformt. Durch Ansteuern der Linearführungen 31 und 33 kann die Teilfläche 161 der Anschlussdose 165 mit der ersten Seite 211 des ersten Heizelements 21 in Kontakt gebracht werden. Hierdurch wird die Anschlussdose 165 zumindest teilweise bis über die Glasübergangstemperatur erwärmt.

Weiterhin steht eine zweite Linearführung 32 zur Verfügung. Auch die zweite Linearführung 32 ist durch Antriebsmittel 322 bewegbar. Durch Ansteuern der Antriebsmittel, beispielsweise durch einen Mikroprozessor, einen Mikrokontroller oder eine speicherprogrammierbare Steuerung, kann ein an der zweiten Linearführung 32 befestigtes zweites Heizelement 22 bewegt werden. Das zweite Heizelement 22 weist eine zur Teilfläche 133 des Photovoltaikmoduls 1 komplementär geformte zweite Seite 221 auf. Durch nicht dargestellte Fördereinrichtungen wird das Photovoltaikmodul 1 so in den Arbeitsbereich der zweiten Linearführung 32 bewegt, dass das zweite Heizelement 22 auf die Rückseite 131 des Photovoltaikmoduls 1 in der Teilfläche 133 abgesetzt werden kann. Hierdurch wird eine Teilfläche 133 der Rückseite 131 auf eine Temperatur oberhalb der Glasübergangstemperatur erwärmt.

Nachdem beide Fügepartner hinreichend erwärmt wurden, kann die zweite Heizeinrichtung 22 mittels der Linearführung 32 von der Teilfläche 133 entfernt werden. Nachfolgend wird durch Ansteuern der Linearführungen 31 und 33 die Anschlussdose 165 vom ersten Heizelement 21 entfernt und mit vorgebbarer Anpresskraft auf die Teilfläche 133 der Rückseite 131 des Photovoltaikmoduls 1 aufgelegt. Nach Abkühlen unterhalb der Glasübergangstemperatur ist die Anschlussdose 165 dauerhaft und zuverlässig mit dem Photovoltaikmodul 1 verbunden.

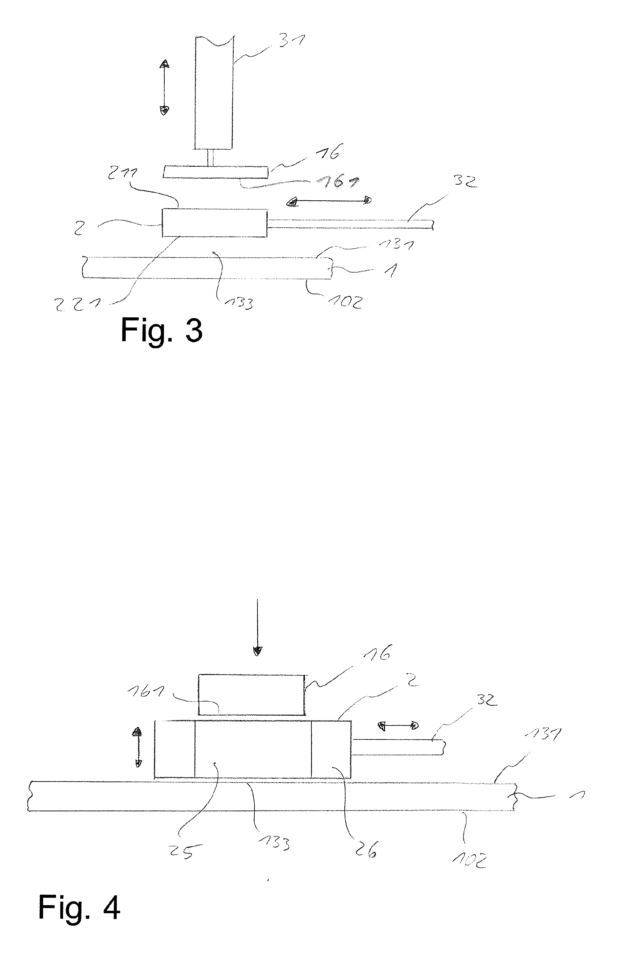

Figur 3 zeigt eine erste Variante einer Vorrichtung zur Durchführung des vorgeschlagenen Verfahrens. Gleiche Bestandteile der Erfindung sind mit gleichen Bezugszeichen versehen, so dass sich die nachfolgende Beschreibung auf die wesentlichen Unterschiede beschränkt.

Auch Figur 3 zeigt einen Ausschnitt aus dem Querschnitt eines Photovoltaikmoduls 1 mit einer Vorderseite bzw. Lichteintrittsfläche 102 und Rückseite 131. Auf einer Teilfläche 133 der Rückseite 131 soll ein Bauteil 16 befestigt werden, beispielsweise eine Anschlussdose.

Zur Erwärmung der Rückseitenfolie des Photovoltaikmoduls 1 und des Bauteils 16 über die Glasübergangstemperatur dient ein Heizelement 2. Das Heizelement 2 weist eine erste Seite 211 auf, welche komplementär zur Kontaktfläche des Bauteils 16 geformt ist. Weiterhin weist das Heizelement 2 eine gegenüberliegende zweite Seite 221 auf, welche komplementär zur Teilfläche 133 des Photovoltaikmoduls 1 geformt ist. Im einfachsten Fall, d.h. wenn die Rückseite 131 des Photovoltaikmoduls 1 eben ist, sind auch die erste Seite 211 und zweite 221 des Heizelements 2 eben.

Das Heizelement 2 wird auf eine vorgebbare Temperatur gebracht, um in Abhängigkeit der Materialstärke und der Materialbeschaffenheit der Rückseitenfolie und des Bauteils 13 in einer vorgebbaren Zeitspanne eine hinreichende Erwärmung zu ermöglichen. In einigen Ausführungsformen der Erfindung kann die Temperatur der ersten Seite 211 und der zweiten Seite 221 unterschiedlich gewählt sein. Dies kann beispielsweise dadurch erfolgen, dass eine Widerstandsheizung des Heizelements 2 näher an einer Seite angeordnet ist oder zumindest eine Seite mit einer Wärmedämmschicht gegen den Wärmestrom einer Widerstandsheizung teilweise abgeschirmt ist oder eine Wärmedämmschicht in der Mitte des Querschnittes des Heizelementes 2 angeordnet ist und beidseitig Widerstandsheizungen angeordnet sind, welche jeweils eine Seite beheizen.

Zur Durchführung des Schweißvorgangs wird das Bauteil 16 mit einer ersten Linearführung 31 über der Teilfläche 133 positioniert. Mittels einer zweiten Linearführung 32 wird das Heizelement 2 zwischen dem Bauteil 16 und der Rückseite 131 positioniert. Sodann kann durch Absenken des Bauteils 16 sowohl die Rückseite 131 des Photovoltaikmoduls 1 als auch die Kontaktfläche des Bauteils 16 mit dem Heizelement 2 in Kontakt gebracht werden.

Nach hinreichender Erwärmung wird über die Linearführung 31 der Anpressdruck vermindert, so dass das Heizelement 2 entfernt werden kann. Durch erneutes Absenken des Bauteils 16 auf das Photovoltaikmodul 1 wird das Bauteil 16 mit einem vorgebbaren Anpressdruck auf die für die Montage vorgesehene Teilfläche 133 gefügt. Nach Abkühlen unterhalb der Glasübergangstemperatur kann die Linearführung 31 entfernt werden und das Bauteil 16 ist dauerhaft mit dem Photovoltaikmodul 1 verbunden.

Figur 4 erläutert eine Vorrichtung zur Durchführung einer dritten Verfahrensvariante gemäß der Erfindung. Auch in diesem Fall sind gleiche Bestandteile der Erfindung mit gleichen Bezugszeichen versehen.

Wie bereits erläutert zeigt Figur 4 einen Ausschnitt aus einem Photovoltaikmodul 1. Gemäß der dritten Verfahrensvariante soll ein Bauteil 16, beispielsweise eine Anschlussdose, mit der Kontaktfläche 161 auf einer Teilfläche 133 der Rückseite 131 des Photovoltaikmoduls 1 verschweißt werden. Hierzu kann das Bauteil 16 mittels einer nicht dargestellten Linearführung entlang des dargestellten Pfeils bewegt werden, bis die Anlagefläche 161 Kontakt mit der Rückseite 131 des Photovoltaikmoduls 1 hat.

Im nächsten Verfahrensschritt kann ein ringförmiges Heizelement 2 mittels einer zweiten Linearführung 32 so an die Fügestelle herangeführt werden, dass das Bauteil 16 in einer zugeordneten Ausnehmung 25 des Heizelements 2 aufgenommen wird. Die Aussparung 25 kann von ringförmigen Heizelementen 26 umgeben sein, so dass Wärme zumindest in den Randbereich der Kontaktfläche 161 und der Teilfläche 133 eingetragen wird. Dieser Wärmestrom kann zur Erwärmung der Fügepartner über die Glasübergangstemperatur führen. Sodann wird das Heizelement 2 von der Fügestelle entfernt, so dass die Temperatur wieder unter die Glasübergangstemperatur sinkt und eine dauerhafte Verschweißung des Bauteils 16 auf der Rückseite 131 erfolgt.

In einer Variante zur Verfahrensführung kann auch das Heizelement 2 zunächst mit seiner Ausnehmung 25 über der Teilfläche 133 positioniert werden, ehe das Bauteil 16 von oben in die Ausnehmung 25 eingeführt wird. Hierdurch kann der Wärmeeintrag in die Rückseite 131 aufgrund der verlängerten Einbaudauer vergrößert sein.

In wiederum einer alternativen Ausführungsform des Verfahrens kann das Bauteil 16 zunächst in die Ausnehmung 25 eingeführt werden, so dass ein Wärmestrom des Heizelementes 2 auf das Bauteil 16 einwirkt. Sodann kann das Heizelement 2 zusammen mit dem Bauteil 16 auf die Rückseite 131 abgesenkt werden. In diesem Fall wird der Wärmeeintrag in das Bauteil 16 aufgrund der verlängerten Einwirkdauer des Wärmestroms der Heizeinrichtung 2 größer sein als der Wärmestrom in die Rückseite 131.

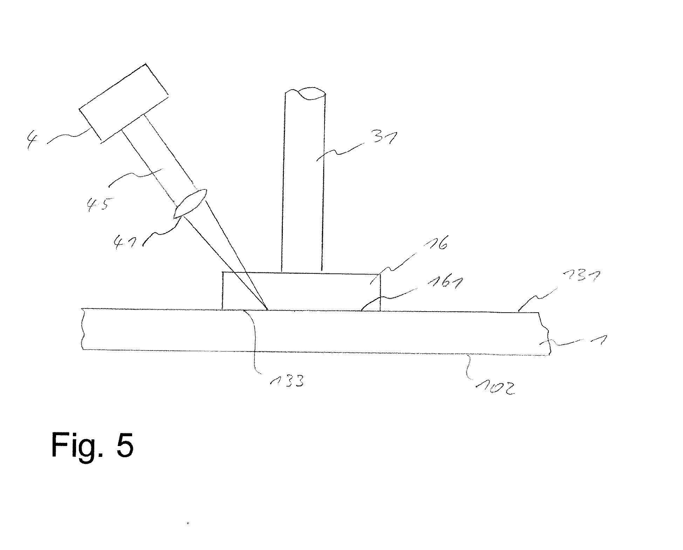

Figur 5 zeigt eine vierte Ausführungsform des Verfahrens bzw. eine hierzu verwendbare Vorrichtung. Wie bereits vorstehend erläutert zeigt Figur 5 einen Ausschnitt aus einem Photovoltaikmodul 1 mit einer Rückseite 131, wobei auf einer Teilfläche 133 ein Bauteil 16 mit einer Kontaktfläche 161 anliegt. Gemäß der dargestellten Ausführungsform soll das Bauteil 16 mit einer Linearführung 31 auf der Rückseite 131 positioniert werden. Sodann wirkt eine elektromagnetische Strahlung 45 auf die Teilfläche 133 bzw. die Kontaktfläche 161 ein, um zumindest eine Oberfläche lokal über die Glasübergangstemperatur zu erwärmen. Hierzu kann die elektromagnetische Strahlung 45 aus dem infraroten Spektralbereich gewählt werden und beispielsweise eine Wellenlänge zwischen etwa 50 µm und etwa 1 µm aufweisen.

In einigen Ausführungsformen kann die elektromagnetische Strahlung 45 durch eine optionale Linse 41 fokussiert werden, so dass die elektromagnetische Strahlung 45 das Bauteil 16 mit geringer Intensität durchdringen kann und der maximale Energieeintrag an der Fügestelle 133 und 161 erfolgt. Die elektromagnetische Strahlung 45 kann kohärent oder inkohärent sein. In einigen Ausführungsformen der Erfindung kann als Strahlungsquelle 4 kohärenter Strahlung beispielsweise ein CO₂-Laser oder ein Diodenlaser verwendet werden.

Um die Absorption der elektromagnetischen Strahlung 45 auf die Fügestelle zu konzentrieren, kann auf der Teilfläche 133 und/oder der Kontaktfläche 161 ein strahlungsabsorbierender Farbstoff eingebracht bzw. aufgebracht sein. Hierzu kann der Farbstoff durch Drucken, Aufsprühen oder Aufrakeln auf die Kontaktstelle gebracht werden oder bei der Herstellung der Rückseitenfolie des Photovoltaikmoduls 1 bzw. des Bauteils 16 in den Kunststoff eingebettet werden.

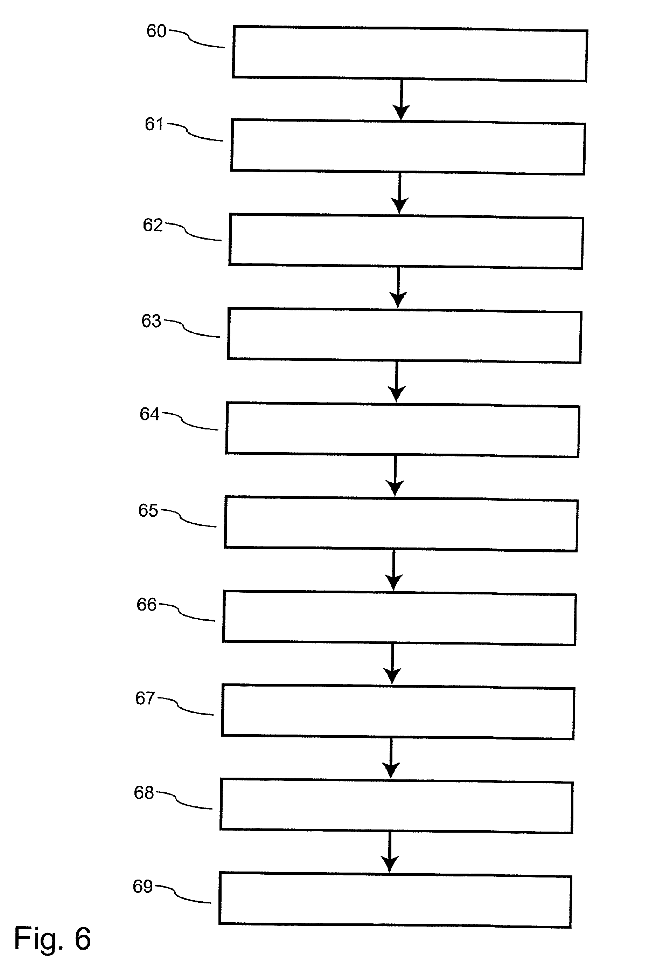

Figur 6 erläutert nochmals eine erste Ausführungsform des erfindungsgemäßen Verfahrens anhand eines Flussdiagramms. Im ersten Verfahrensschritt 60 wird das Bauteil, beispielsweise eine Kabelführung, eine Anschlussdose oder ein Rückseitenverstärkung von einer Linearführung oder einem Industrieroboter aufgenommen. Im zweiten Verfahrensschritt 61 wird das Bauteil 16 über die zu schweißende Stelle am Photovoltaikmodul 1 transportiert. Nachfolgend wird im dritten Verfahrensschritt 62 das Heizelement 2 zwischen dem Bauteil 16 und dem Photovoltaikmodul 1 bzw. dessen Rückseite 131 eingeführt.

Schließlich wird im vierten Verfahrensschritt 63 das Heizelement auf die Rückseite des Photovoltaikmoduls abgesenkt. Im direkt anschließenden fünften Verfahrensschritt 64 wird das Bauteil 16 ebenfalls auf das Heizelement abgesenkt. Im sechsten Verfahrensschritt 65 wird mittels der Linearführung bzw. dem Industrieroboter der Anpressdruck auf das Bauteil, das Heizelement und das Photovoltaikmodul ausgeübt, so dass ein hinreichender Wärmeübergang vom Heizelement auf die zu fügenden Bauteile erfolgt.

Im siebten Verfahrensschritt 66 wird das Bauteil 16 abgehoben, so dass auch die Anpresskraft auf das Heizelement abnimmt. Hierauf kann das Heizelement im achten Verfahrensschritt 67 von der Oberfläche des Photovoltaikmoduls 1 entfernt werden.

Im neunten Verfahrensschritt 68 wird das Bauteil 16 mit der aufgeheizten Teilfläche 133 am Photovoltaikmodul 1 zusammengeführt. Im zehnten Verfahrensschritt 69 erfolgt schließlich das Aufbringen eines vorgebbaren Pressdruckes, um die Verschweißung auszuführen. Nach dem Abkühlen des Photovoltaikmoduls 1 und des Bauteils 16 ist das Verfahren abgeschlossen und das Bauteil 16 dauerhaft am Photovoltaikmodul 1 befestigt.

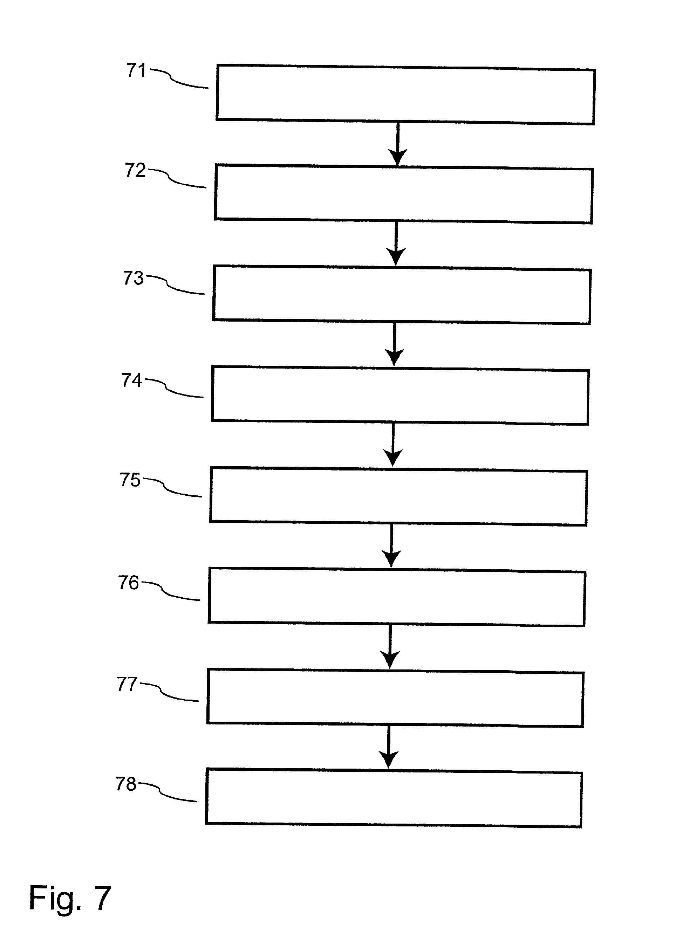

Figur 7 erläutert eine zweite Ausführungsform des erfindungsgemäßen Verfahrens anhand eines Flussdiagramms. Im ersten Verfahrensschritt 71 wird das Bauteil 16 durch einen Industrieroboter oder eine Linearführung aufgenommen. Im zweiten Verfahrensschritt 72 wird das Bauteil 16 über ein ortsfest montiertes ersten Heizelement positioniert. Hierauf erfolgt im dritten Verfahrensschritt 73 das Absenken des Bauelements 16 auf das erste Heizelement, wobei ein vorgebbarer Anpressdruck auf das Heizelement ausgeübt wird, um einen Wärmeübergang zu ermöglichen.

Zeitlich vorher, gleichzeitig oder nachher wird im fünften Verfahrensschritt 75 ein zweites Heizelement mittels einer Linearführung oder anderen Antriebsmitteln auf der für die Montage vorgesehenen Teilfläche 133 der Rückseite 131 des Photovoltaikmoduls 1 positioniert. Weiterhin umfasst der fünfte Verfahrensschritt 75 das Absenken und Anpressen des zweiten Heizelementes, so dass zumindest die Teilfläche 133 erwärmt wird.

Im sechsten Verfahrensschritt 76 wird das Bauteil vom ersten Heizelement abgehoben. Weiterhin wird auch das zweite Heizelement nach hinreichender Einwirkdauer von der Rückseite 131 abgehoben. Im siebten Verfahrensschritt 77 wird das Bauteil durch die Linearführung über dem Photovoltaikmodul 1 positioniert. Im nachfolgenden achten Verfahrensschritt erfolgt der Abschluss der Verschweißung durch Absenken des Bauteils 16, Anpressen mit vorgebbaren Pressdruck und Halten dieser Verbindung bis zur hinreichenden Abkühlung der Fügepartner.

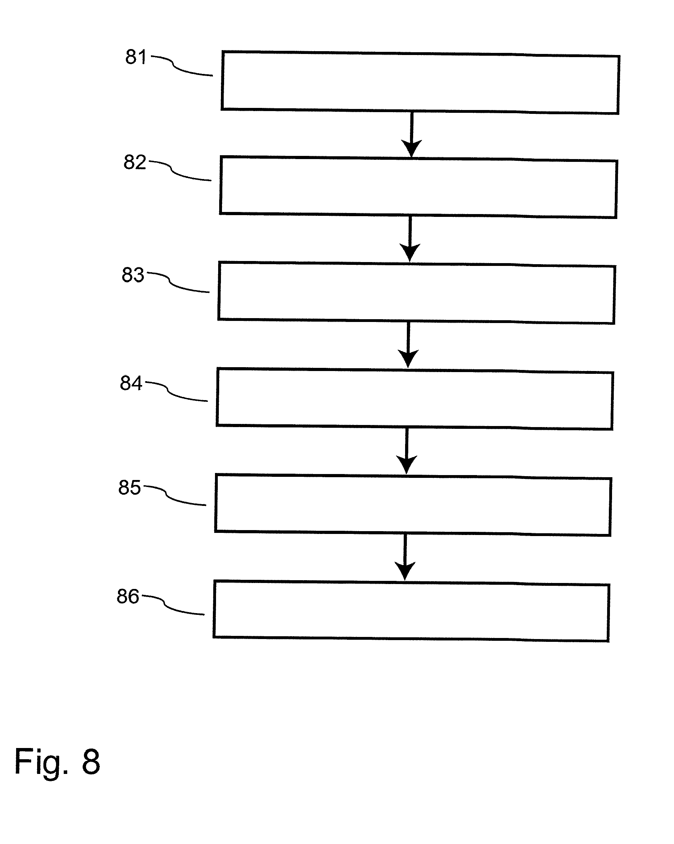

Figur 8 erläutert eine dritte Ausführungsform des erfindungsgemäßen Verfahrens anhand eines Flussdiagramms. Wie bereits vorstehend beschrieben, wird im ersten Verfahrensschritt 81 das Bauteil aufgenommen. Im zweiten Verfahrensschritt 82 wird ein ringförmiges Heizelement durch eine Linearführung oder andere geeignete Antriebsmittel über der Rückseite 131 des Photovoltaikmoduls 1 positioniert.

Im dritten Verfahrensschritt 83 wird das Bauteil 16 in eine Aussparung des ringförmigen Heizelements eingeführt. Optional kann das Bauteil 16 nun innerhalb des Heizelements für eine vorgebbare Zeitspanne gehalten werden, um eine Vorerwärmung der Kontaktfläche 161 des Bauteils 16 zu erzielen.

Im vierten Verfahrensschritt 84 wird das Heizelement auf die Teilfläche 133 des Photovoltaikmoduls 1 abgesenkt. Unmittelbar darauf wird der fünfte Verfahrensschritt 85 ausgeführt, in welchem auch das Bauteil 16 weiter in die Ausnehmung 25 des ringförmigen Heizelements 2 eingeführt wird, so dass das Bauteil 16 auf der Rückseite 131 anliegt.

Im sechsten Verfahrensschritt 86 erfolgt ein lokaler Wärmeeintrag in die Kontaktstelle zwischen Photovoltaikmodul 1 und Bauteil 16, wobei durch das umschließende Heizelement vermehrt ein Wärmeeintrag an die Außenkante der Fügestelle erfolgt. Im nicht dargestellten siebten Verfahrensschritt wird das Heizelement entfernt und der Pressdruck zwischen den Fügepartnern nach hinreichender Abkühlung der Bauteile aufgehoben.

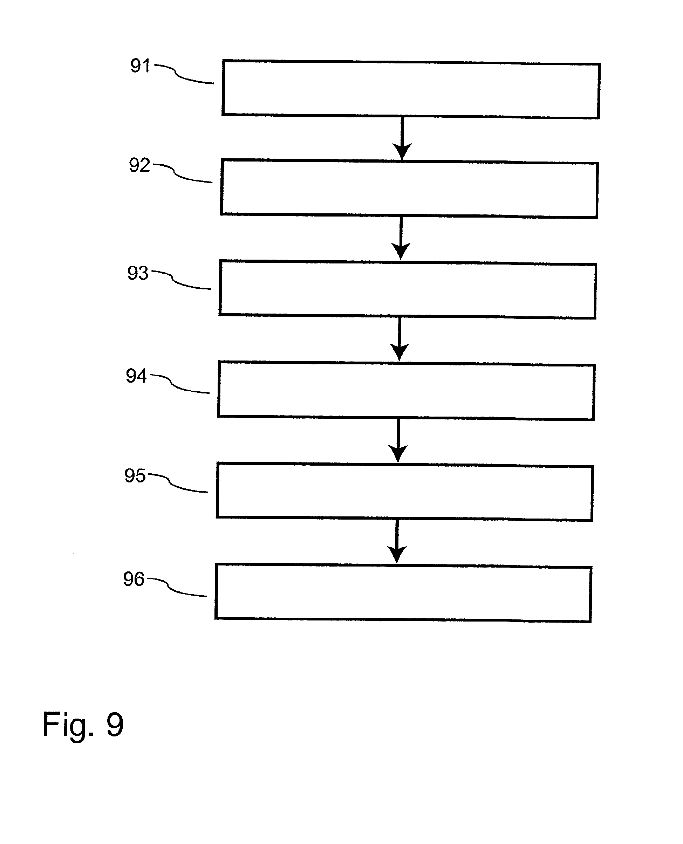

Figur 9 erläutert eine vierte Ausführungsform des erfindungsgemäßen Verfahrens anhand eines Flussdiagramms. Auch der erste Verfahrensschritt 91 nach der vierten Ausführungsform umfasst das Aufnehmen des Bauteils 16. Im zweiten Verfahrensschritt 92 wird das Bauteil 16 durch eine Linearführung oder gleichwirkende Mittel über der Teilfläche 133 des Photovoltaikmoduls 1 positioniert. Im dritten Verfahrensschritt 33 wird das Bauteil 16 abgesenkt und mit vorgebbarem Anpressdruck auf die Rückseite des Photovoltaikmoduls gepresst.

Im nachfolgenden vierten Verfahrensschritt 94 kann eine Strahlungsquelle mittels eines Roboterarms an die Fügestelle geführt werden. In einigen Ausführungsformen der Erfindung kann im vierten Verfahrensschritt 94 ein Laser an die Schweißstelle herangeführt werden, welcher an einem Roboterarm fixiert ist.

Im fünften Verfahrensschritt 95 beginnt der eigentliche Schweißvorgang, in dem eine elektromagnetische Strahlung an der Fügestelle absorbiert wird, um eine hinreichende Erwärmung zumindest eines Fügepartners zu erzielen. Hierzu erfolgt die Aktivierung der Strahlungsquelle, wobei die erzeugte elektromagnetische Strahlung fallweise durch Bewegen der Strahlungsquelle an vorgebbare Stellen der Fügestelle geführt wird. Beispielsweise kann die Strahlungsquelle entlang des Umfangs eines kreisförmigen Bauteils rotieren oder entlang der Längserstreckung eines langgestreckten Bauteils bewegt werden. Der Wärmeeintrag kann hierbei entweder in die Oberfläche eines Fügepartners oder in beide Fügepartner erfolgen, so dass entweder nur ein Fügepartner unmittelbar aufschmilzt oder beide Fügepartner aufschmelzen.

Im sechsten Verfahrensschritt 96 wird die Strahlungsquelle deaktiviert und der Anpressdruck zwischen Bauteil und Photovoltaikmodul bis zur vollständigen Erstarrung der Fügestelle aufrechterhalten.

Selbstverständlich ist die Erfindung nicht auf die in den Figuren dargestellten Ausführungsformen beschränkt. Die vorstehende Beschreibung ist daher nicht als beschränkend, sondern als erläuternd anzusehen. Die nachfolgenden Ansprüche sind so zu verstehen, dass ein genanntes Merkmal in zumindest einer Ausführungsform der Erfindung vorhanden ist. Dies schließt die Anwesenheit weiterer Merkmale nicht aus. Sofern die Ansprüche und die vorstehende Beschreibung "erste" und "zweite" Merkmale definieren, so dient diese Bezeichnung der Unterscheidung zweier gleichartiger Merkmale, ohne eine Rangfolge festzulegen.

## Patentansprüche

1. Verfahren zur Herstellung eines Photovoltaikmoduls (1), bei welchem zumindest eine mit Anschlusskontakten (151) versehene photovoltaische Zelle (15) auf ein Trägermaterial (10) aufgebracht wird und nachfolgend das Trägermaterial (10), die Zelle (15) und zumindest eine Rückseitenfolie (13) flächig miteinander verbunden werden, wobei weiterhin zumindest ein auf der Rückseite (131) des Photovoltaikmoduls angeordnetes Bauteil (16) mit der Rückseitenfolie (13) verschweißt wird, **gekennzeichnet durch** die folgenden Schritte:
Aufnehmen und Positionieren des Bauteils (16) über der für die Montage vorgesehenen Teilfläche (133) der Rückseite (131) des Photovoltaikmoduls (1),
Positionieren eines Heizelementes (2) zwischen dem Bauteil (16) und zumindest der für die Montage vorgesehenen Teilfläche (133) der Rückseite (131) des Photovoltaikmoduls (1),
Einbringen von Wärmeenergie in die für die Montage vorgesehenen Teilfläche (133) und zumindest eine Teilfläche (161) des Bauteiles (16),
Entfernen des Heizelementes (2),
Zusammenführen des Bauteils (16) und der für die Montage vorgesehenen Teilfläche (133) mit einem vorgebbaren Anpressdruck,
Abkühlen des Bauteils (16) und des Photovoltaikmoduls (1) unter die Glasübergangstemperatur.

2. Verfahren nach Anspruch 1, **dadurch gekennzeichnet, dass** das Heizelement eine zu der für die Montage vorgesehenen Teilfläche (133) der Rückseite (131) des Photovoltaikmoduls (1) komplementär geformte zweite Seite (221) und eine zu der Teilfläche (161) des Bauteiles (16) komplementär geformte erste Seite (211) aufweist.

3. Verfahren nach Anspruch 1, **dadurch gekennzeichnet, dass** das Heizelement (2) eine zu der für die Montage vorgesehenen Teilfläche (133) der Rückseite (131) des Photovoltaikmoduls (1) komplementär geformte zweite Seite (221) aufweist und weiterhin eine Aussparung (25) aufweist, welche zur Aufnahme zumindest eines Teilvolumens des Bauteils (16) ausgebildet ist.

4. Verfahren nach Anspruch 1, **dadurch gekennzeichnet, dass** das Heizelement (2) ringförmig ist.

5. Verfahren dem Oberbegriff des Anspruchs 1, **gekennzeichnet durch** die folgenden Schritte:
Aufnehmen und Positionieren des Bauteils (16) über einem ersten Heizelement (21),
Positionieren eines zweiten Heizelementes (22) auf der für die Montage vorgesehenen Teilfläche (133) der Rückseite (131) des Photovoltaikmoduls (1),
Einbringen von Wärmeenergie in die für die Montage vorgesehenen Teilfläche (133) und zumindest eine Teilfläche (161) des Bauteils (16),
Entfernen der Heizelemente (21, 22),
Zusammenführen des Bauteils (16) und der für die Montage vorgesehenen Teilfläche (133) mit einem vorgebbaren Anpressdruck,
Abkühlen des Bauteils (16) und des Photovoltaikmoduls (1) unter die Glasübergangstemperatur.

6. Verfahren nach Anspruch 5, **dadurch gekennzeichnet, dass** das zweite Heizelement (22) eine zu der für die Montage vorgesehenen Teilfläche (133) der Rückseite (131) des Photovoltaikmoduls (1) komplementär geformte Oberfläche (221) aufweist.

7. Verfahren nach Anspruch 5 oder 6, **dadurch gekennzeichnet, dass** das erste Heizelement (21) eine zu der Teilfläche (161) des Bauteiles (16) komplementär geformte Oberfläche (211) aufweist und/oder dass das erste Heizelement (21) unbeweglich ist.

8. Verfahren nach einem der Ansprüche 1 bis 7, **dadurch gekennzeichnet, dass** das Heizelement (2) und/oder das erste Heizelement (21) und/oder das zweite Heizelement (22) durch Induktionsheizung und/oder durch Widerstandsheizung beheizbar ist.

9. Verfahren dem Oberbegriff des Anspruchs 1, **gekennzeichnet durch** die folgenden Schritte:
Aufnehmen und Positionieren des Bauteils (16) auf der für die Montage vorgesehenen Teilfläche (133) der Rückseite (131) des Photovoltaikmoduls (1),
Aussetzen des Verbindungsbereiches (133, 161) einer elektromagnetischen Strahlung (45), so dass ein Aufschmelzen zumindest einer Oberfläche erfolgt,
Abkühlen des Bauteils (16) und des Photovoltaikmoduls (1) unter die Glasübergangstemperatur.

10. Verfahren nach Anspruch 9, **dadurch gekennzeichnet, dass** zwischen dem Bauteil (16) und der für die Montage vorgesehenen Teilfläche (133) der Rückseite (131) des Photovoltaikmoduls (1) ein strahlungsabsorbierender Farbstoff eingebracht ist.

11. Verfahren nach Anspruch 9 oder 10, **dadurch gekennzeichnet, dass** die elektromagnetische Strahlung kohärent ist.

12. Verfahren nach einem der Ansprüche 1 bis 11, gekennzeichnet, dass das Bauelement (16) ausgewählt ist aus einer Anschlussdose (165) und/oder einer Rückseitenverstärkung (166) und/oder einem Rahmen und/oder einem Kabel und/oder einer Kabelhalterung und/oder einem Befestigungselement.

13. Verfahren nach einem der Ansprüche 1 bis 12, **dadurch gekennzeichnet, dass** das Bauelement (16) und/oder zumindest ein Heizelement (2, 21, 22) mittels eines Linearantriebs (31, 32) bewegbar ist.

14. Verfahren nach einem der Ansprüche 1 bis 13, **dadurch gekennzeichnet, dass** das Bauelement (16) aus einem thermoplastischen Kunststoff besteht oder einen solchen enthält.

15. Verfahren nach einem der Ansprüche 1 bis 14, **dadurch gekennzeichnet, dass** das Bauelement (16) und/oder die Rückseitenfolie (13) aus einem teilkristallinen Kunststoff besteht oder einen solchen enthält.
